(19) Europäisches Patentamt
European Patent Office
Office européen des brevets

(11) Veröffentlichungsnummer: **0 066 681**
**B1**

# (12) EUROPÄISCHE PATENTSCHRIFT

(45) Veröffentlichungstag der Patentschrift: **27.11.85**

(51) Int. Cl.⁴: **G 01 R 29/02**, G 01 R 25/00, G 01 D 5/246

(21) Anmeldenummer: **82102552.5**

(22) Anmeldetag: **26.03.82**

(54) **Verfahren zur Ermittlung einer dem Tastverhältnis entsprechenden Grösse eines periodischen elektrischen Rechtecksignals und Verfahren zur Ermittlung des Phasenwinkels zwischen zwei zueinander phasenverschobenen, periodischen elektrischen Rechtsignalen und Anordnung zur Durchführung dieser Verfahren.**

(30) Priorität: **06.06.81 DE 3122702**

(43) Veröffentlichungstag der Anmeldung: **15.12.82 Patentblatt 82/50**

(45) Bekanntmachung des Hinweises auf die Patenterteilung: **27.11.85 Patentblatt 85/48**

(84) Benannte Vertragsstaaten: **AT CH FR GB IT LI NL SE**

(56) Entgegenhaltungen:
**DE - A - 2 729 697**
**DE - B - 1 179 634**
**DE - B - 1 948 869**

**MARCONI INSTRUMENTATION, Band 14, Nr. 5, Oktober 1974, Seiten 105-108, A.M. RUDKIN: "A new approach to phase measurement"**
**ELEKTOR, Band 6, Nr. 7/8, Juli/August 1980, Seiten 7-27, N. NAZOA-RUIZ: "Phase meter"**
**ELECTRONIC ENGINEERING, Band 50, Nr. 607, Mai 1978, Seite 13, S. GOTTARDI et al.: "Detector measures phase over full 360o range"**

**Die Akte enthält technische Angaben, die nach dem Eingang der Anmeldung eingereicht wurden und die nicht in dieser Patentschrift enthalten sind.**

(73) Patentinhaber: **Dr. Johannes Heidenhain GmbH, Nansenstrasse 17, D-8225 Traunreut (DE)**

(72) Erfinder: **Vollmayr, Norbert, Dipl.-Ing., Bruckauerweg 2, D-8221 Traunwalchen (DE)**

EP 0 066 681 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zur Ermittlung einer dem Tastverhältnis entsprechenden Grösse eines periodischen elektrischen Rechtecksignals gemäss dem Oberbegriff des Anspruches 1 und ein Verfahren zur Ermittlung des Phasenwinkels zwischen zwei zueinander phasenverschobenen, periodischen elektrischen Rechtecksignalen gemäss dem Oberbegriff des Anspruches 2 sowie Anordnungen gemäss den Ansprüchen 7 und 8 zur Durchführung dieser Verfahren.

Aus der DE-B-19 48 869 ist es bekannt, eine dem Tastverhältnis entsprechende Grösse aus einem periodischen Rechtecksignal mittels eines Verfahrens, wie im Oberbegriff des Anspruchs 1 angegeben, zu ermitteln und dazu eine Anordnung zu verwenden, wie sie im Oberbegriff des Anspruches 7 angegeben ist.

Aus der Zeitschrift «Elektor», Band 6, Nr. 7/8, Juli/August 1980, Seite 7–27 ist es bekannt, den Phasenwinkel zwischen zwei zueinander phasenverschobenen, periodischen Rechtecksignalen, wie im Oberbegriff des Anspruches 2 angegeben, zu ermitteln und dazu eine Anordnung zu verwenden, wie sie im Oberbegriff des Anspruches 8 angegeben ist.

Aus der DE-C-11 79 634 ist ein Verfahren und eine Einrichtung zur Erfassung und Zuordnung des zwischen zwei Wechselströmen oder Wechselspannungen auftretenden Phasenwinkels bekannt, bei dem zwei Rechtecksignale mit gleichem Tastverhältnis einer logischen Gatterschaltung zugeführt werden, an deren Ausgängen ein Rechtecksignal ansteht, dessen zeitlicher Mittelwert proportional dem Betrag des Phasenwinkels ist. An die Ausgänge der Gatterschaltung kann ein stromrichtungsempfindliches Messinstrument angeschlossen werden, dessen Nullage sich in der Skalenmitte befindet, so dass der Phasenwinkel nach Betrag und Richtung direkt angezeigt werden kann. Bei dieser Einrichtung ist die analoge Anzeige des Phasenwinkels durch ein Zeigerinstrument in der Genauigkeit begrenzt; hinzu kommt eine gewisse Ableseungenauigkeit, die durch eine Zeigerunruhe bei niedrigen Frequenzen der Rechtecksignale noch verstärkt wird, Des weiteren müssen die logischen Pegel der beiden Ausgangsgatter der Gatterschaltung in ihrer Grösse genau übereinstimmen und daher abgeglichen werden. Dieser Abgleich ist nicht nur schwierig und zeitaufwendig, er muss auch von Zeit zu Zeit erneut vorgenommen werden.

Aus der Druckschrift «Marconi Instrumentation», Band 14, Nr. 5, 1974, Seiten 105 bis 108 ist eine erste Einrichtung zur Ermittlung des Phasenwinkels zwischen zwei periodischen elektrischen Rechtecksignalen bekannt. Die Rechtecksignale werden jeweils über eine Differenzierstufe einer bistabilen Schaltstufe zugeführt, deren Ausgangssignal nach Durchlaufen eines Filters als Mittelwert einem Voltmeter zur direkten analogen Anzeige des Phasenwinkels zugeleitet wird. In einer zweiten Einrichtung werden die beiden Rechtecksignale direkt einer digitalen Verarbeitungseinheit zugeführt, die den Phasenwinkel aus bestimmten Zeitintervallen zwischen den Rechtecksignalen berechnet.

Der Erfindung liegt die Aufgabe zugrunde, Verfahren und Anordnungen zur Ermittlung einer dem Tastverhältnis entsprechenden Grösse eines periodischen elektrischen Rechtecksignals und zur Ermittlung des Phasenwinkels zwischen zwei zueinander phasenverschobenen, periodischen elektrischen Rechtecksignalen anzugeben, die die Nachteile bekannter Verfahren und Vorrichtungen beseitigen und mit einfachen Mitteln eine genaue Ermittlung der vorgenannten Signalparameter erlauben; des weiteren soll die Erfindung insbesondere bei digitalen elektrischen Positionsmesseinrichtungen auf einfache Weise anwendbar sein.

Diese Aufgabe wird erfindungsgemäss durch die in den Ansprüchen 1,7 und 2,8 angegebenen Merkmale gelöst.

Die mit der Erfindung erzielten Vorteile bestehen insbesondere darin, dass die vorgeschlagenen Verfahren eine exakte Ermittlung jeweils der dem Tastverhältnis entsprechenden Grösse eines periodischen Rechtecksignals oder des Phasenwinkels zwischen zwei zueinander phasenverschobenen, periodischen Rechtecksignalen ohne jeglichen Abgleich der logischen Pegel der Gatter ermöglicht. Zudem kann der Phasenwinkel zwischen zwei phasenverschobenen Rechtecksignalen auch bei unterschiedlichen Tastverhältnissen exakt ermittelt werden.

Die Anordnungen zur Durchführung der erfindungsgemässen Verfahren sind einfach im Aufbau und überdies leicht in digitale elektrische Positionsmesseinrichtungen unter Ausnutzung bereits in diesen Messeinrichtungen vorhandener Bauelemente integrierbar. Eine derartige digitale elektrische Positionsmesseinrichtung ist beispielsweise in der DE-A-27 29 697 beschrieben, die einen Umsetzer, einen Digitalrechner und eine Anzeigeeinheit aufweist; diese letztgenannten Baueinheiten können zur Durchführung der vorgeschlagenen Verfahren herangezogen werden.

Weitere vorteilhafte Ausgestaltungen der Verfahren entnimmt man den abhängigen Patentansprüchen.

Die erfindungsgemässen Verfahren finden bevorzugt Anwendung bei einer nicht gezeigten digitalen elektrischen Positionsmesseinrichtung, bei der eine Teilung von einer relativ dazu beweglichen Abtasteinheit abgetastet wird und die in der Abtasteinheit gewonnenen elektrischen Analogsignale einer Auswerte-/Anzeigeeinheit zur Anzeige der Werte der vollen Signalperioden zugeführt werden. Von den gewonnenen elektrischen Analogsignalen wird zur Unterteilung der vollen Signalperioden mindestens ein elektrisches Analogsignal mittels wenigstens eines Umsetzers digitalisiert, und die Digitalwerte werden einem Digitalrechner zur Berechnung von Interpolationswerten zugeleitet. Eine derartige Einrichtung ist in der vorgenannten DE-A-27 29 697 beschrieben. Vor der Durchführung des Interpolationsvorganges durch den Digitalrechner werden bei fehlerhaften Signalparametern der Analogsignale zur Korrektur dieser Signalfehler an den dem Digitalrechner zugeführten Digitalwerten aus den ermittelten Signalparametern Korrekturwerte berechnet und in den Digitalrechner eingegeben. Die gespeicherten Korrekturwerte werden bei der Interpolation vom Digitalrechner automatisch verwertet.

Anhand der Zeichnungen werden Schaltungsanordnungen zur Ausübung der Verfahren erläutert.

Es zeigen

Figur 1 eine Schaltungsanordnung zur Ermittlung einer dem Tastverhältnis entsprechenden Grösse eines periodischen Rechtecksignals;

Figur 2 eine Schaltungsanordnung anhand der die Ermittlung des Phasenwinkels zwischen zwei zueinander phasenverschobenen, periodischen Rechtecksignalen erläutert wird;

Figur 3 eine bevorzugte Schaltungsanordnung zur Ermittlung einer dem Tastverhältnis entsprechenden Grösse eines periodischen Rechtecksignals;

Figur 4 eine bevorzugte Schaltungsanordnung anhand der die Ermittlung des Phasenwinkels zwischen zwei zueinander phasenverschobenen, periodischen Rechtecksignalen erläutert wird;

Figur 5 die Signalverläufe in der Schaltungsanordnung nach Figur 3;

Figur 6 die Signalverläufe in der Schaltungsanordnung nach Figur 4;

Figur 7 eine logische Funktionstabelle der Signale nach Figur 5 und

Figur 8 eine logische Funktionstabelle der Signale nach Figur 6.

Gemäss Figur 1 wird ein periodisches Rechtecksignal S mit dem zu messenden Tastverhältnis einem Tiefpassfilter F zugeführt, an dessen Ausgang ein arithmetischer Mittelwert $S_2$ erscheint, aus dem mittels eines Umsetzers U ein Zahlenwert M gebildet und einem Digitalrechner R zugeleitet wird; der Zahlenwert M wird durch eine vom Digitalrechner R gesteuerte Anzeigeeinheit Z angezeigt und stellt die dem Tastverhältnis entsprechende Grösse dar.

Die Ermittlung des Phasenwinkels α zwischen zwei zueinander phasenverschobenen, periodischen Rechtecksignalen $S_V$, $S_R$ erfolgt durch die Schaltungsanordnung nach Figur 2. Die phasenverschobenen Rechtecksignale $S_V$, $S_R$ liegen an den Eingängen eines Exclusiv-Oder-Gatters $G_3'$ an, durch das sie zu einem dritten periodischen Rechtecksignal S' zusammengefasst werden, das dem Eingang eines Tiefpassfilters F' zugeführt wird. Am Ausgang des Tiefpassfilters F' erscheint ein arithmetischer Mittelwert $S_2'$, aus dem mittels eines Umsetzers U' ein Zahlenwert M' gebildet und einem Digitalrechner R' zugeleitet wird. Der Digitalrechner R' errechnet den Phasenwinkel α und bringt ihn in einer Anzeigeeinheit Z' zur Anzeige.

Ein bevorzugtes Verfahren zur Ermittlung der dem Tastverhältnis entsprechenden Grösse eines periodischen Rechtecksignals bzw. des Phasenwinkels zwischen zwei zueinander phasenverschobenen, periodischen Rechtecksignalen wird anhand der Schaltungsanordnungen nach den Figuren 3 bzw. 4 im folgenden erklärt.

Gemäss Figur 3 liegt ein periodisches Rechtecksignal S mit dem zu messenden Tastverhältnis an einem ersten Eingang $E_1$ einer digitalen Logikschaltung L an, deren Ausgangssignal als viertes periodisches Rechtecksignal $S_1$ nach Durchlaufen eines Tiefpassfilters F mittels eines Umsetzers U digitalisiert und einem Digitalrechner R zugeleitet wird, der je einen weiteren, zweiten und dritten Eingang $E_2$ bzw. $E_3$ der digitalen Logikschaltung L mit digitalen Steuersignalen $P_1$, $P_2$ beaufschlagt.

Die digitale Logikschaltung L besteht aus einem den ersten und zweiten Eingang $E_1$ bzw. $E_2$ aufweisenden Oder-Gatter $G_1$, dessen Ausgang mit einem Eingang eines Und-Gatters $G_2$ verbunden ist, dessen anderer Eingang den dritten Eingang $E_3$ der digitalen Logikschaltung L bildet; der Ausgang A der digitalen Logikschaltung L ist an das Tiefpassfilter F angeschlossen, dessen Grenzfrequenz weit unterhalb der Frequenz des periodischen Rechtecksignals S liegt.

In Figur 5 sind die Signalverläufe in der Schaltungsanordnung gemäss Figur 3 über der Zeit t aufgetragen. In Figur 5a ist das am ersten Eingang $E_1$ der digitalen Logikschaltung L liegende periodische Rechtecksignal S mit einer dem Tastverhältnis entsprechenden Grösse $TV = t_1/t_2$ dargestellt. Das periodische Rechtecksignal S erscheint als viertes periodisches Rechtecksignal $S_1$ (Figur 5b) am Ausgang A der digitalen Logikschaltung L, wenn am zweiten Eingang $E_2$ der digitalen Logikschaltung L ein digitales Steuersignal $P_1 = 0$ (logische Null) und am dritten Eingang $E_3$ ein digitales Steuersignal $P_2 = 1$ (logische Eins) anliegt; diese digitalen Steuersignale $P_1$, $P_2$ stammen vom Digitalrechner R. Das Tiefpassfilter F bildet aus dem vierten periodischen Rechtecksignal $S_1$ den arithmetischen Mittelwert $S_2$ (Figur 5c), der vom Umsetzer U digitalisiert und vom Digitalrechner R als binärer Zahlenwert M für den arithmetischen Mittelwert $S_2$ abgespeichert wird.

Da der untere Signalpegel $SU_1$ des vierten periodischen Rechtecksignals $S_1$ grösser als Null ist (Figur 5b), müssen zur exakten Ermittlung der dem Tastverhältnis entsprechenden Grösse TV des periodischen Rechtecksignals S noch der obere Signalpegel $SO_1$ (logische Eins des vierten periodischen Rechtecksignals $S_1$) und der untere Signalpegel $SU_1$ (logische Null des vierten periodischen Rechtecksignals $S_1$) bestimmt werden. Zur Bestimmung des oberen Signalpegels $SO_1$ wird der zweite Eingang $E_2$ der digitalen Logikschaltung L vom Digitalrechner R mit einem digitalen Steuersignal $P_1 = 1$ (logische Eins) und der dritte Eingang $E_3$ mit einem digitalen Steuersignal $P_2 = 1$ (logische Eins) beaufschlagt, während am ersten Eingang $E_1$ das periodische Rechtecksignal S anliegt; am Ausgang A der digitalen Logikschaltung L erscheint somit der obere Signalpegel $SO_1$ des vierten periodischen Rechtecksignals $S_1$ (Figur 5d), der nach Durchlaufen des Tiefpassfilters F als oberer Signalpegel $SO_2$ (Figur 5e) am Umsetzer U ansteht, von diesem digitalisiert und vom Digitalrechner R als binärer Zahlenwert E für den oberen Signalpegel $SO_1$ des vierten periodischen Rechtecksignals $S_1$ abgespeichert wird.

Zur Bestimmung des unteren Signalpegels $SU_1$ des vierten periodischen Rechtecksignals $S_1$ wird der zweite Eingang $E_2$ der digitalen Logikschaltung L vom Digitalrechner R mit einem digitalen Steuersignal $P_1 = 0$ (logische Null) und der dritte Eingang $E_3$ mit einem digitalen Steuersignal $P_2 = 0$ (logische Null) beaufschlagt, während am ersten Eingang $E_1$ das periodische Rechtecksignal S anliegt; am Ausgang A der digitalen Logikschaltung L erscheint somit der untere Signalpegel $SU_1$ des vierten periodischen Rechtecksignals $S_1$ (Figur 5f), der nach Durchlaufen des Tiefpassfilters F als unterer Signalpegel $SU_2$ (Figur 5g) am Umsetzer U ansteht, von diesem digitalisiert und vom Digitalrechner R als binärer Zahlenwert N für den unteren Signalpegel $SU_1$ des vierten periodischen Rechtecksignals $S_1$ abgespeichert wird.

Die dem Tastverhältnis entsprechende Grösse $TV = (M-N) / (E-M)$ des periodischen Rechtecksignals S wird vom Digitalrechner R berechnet und durch eine Anzeigeeinheit Z in digitaler Form angezeigt. Zur Berechnung der dem Tastverhältnis entsprechenden Grösse TV sowie zur Erzeugung der drei Kombinationen von digitalen Steuersignalen $P_1$, $P_2$ wird der Digitalrechner R entsprechend programmiert; die Abfrage der Signale $S_1$, $SO_1$, $SU_1$ am Ausgang A der Logikschaltung L erfolgt sequentiell in beliebiger Reihenfolge. In Figur 7 sind die Signale $S_1$, $SO_1$, $SU_1$ am Ausgang A der Logikschaltung L als Funktion der Zustände der digitalen Steuersignale $P_1$, $P_2$ tabellarisch dargestellt.

Die Ermittlung des Phasenwinkels $\alpha$ zwischen zwei zueinander phasenverschobenen, periodischen Rechtecksignalen $S_V$, $S_R$ erfolgt durch die Schaltungsanordnung nach Figur 4. Die phasenverschobenen Rechtecksignale $S_V$, $S_R$ liegen an den Eingängen eines Exclusiv-Oder-Gatters $G_3'$ an, durch das sie zu einem dritten periodischen Rechtecksignal S' zusammengefasst werden, das dem ersten Eingang $E_1'$ einer digitalen Logikschaltung L' zugeführt wird.

Die weitere Schaltungsanordnung gemäss Figur 4 entspricht der Schaltungsanordnung nach Figur 3 und ist mit den gleichen, aber gestrichenen Bezugszeichen versehen.

In Figur 6 sind die Signalverläufe in der Schaltungsanordnung gemäss Figur 4 über der Zeit t aufgetragen. In Figur 6a ist das eine der phasenverschobenen Rechtecksignale $S_V$ mit einer dem Tastverhältnis entsprechenden Grösse $TV_V = t_{V1}/t_{V2}$ und in Figur 6b das andere der phasenverschobenen Rechtecksignale $S_R$ mit einer dem Tastverhältnis entsprchenden Grösse $TV_R = t_{R1}/t_{R2}$ dargestellt, die an den nicht näher bezeichneten Eingängen des Exclusiv-Oder-Gatters $G_3'$ liegen, dessen Ausgang das dritte periodische Rechtecksignal S' führt, das in Figur 6c gezeigt ist. Die phasenverschobenen Rechtecksignale $S_V$, $S_R$ weisen unterschiedliche, den jeweiligen Tastverhältnissen entsprechende Grössen $TV_V$, $TV_R$, aber die gleiche Periodendauer T auf.

Das dritte periodische Rechtecksignal S' erscheint am Ausgang A' der digitalen Logikschaltung L' als fünftes periodisches Rechtecksignal $S_1'$ (Figur 6d), wenn am zweiten Eingang $E_2'$ der digitalen Logikschaltung L' ein digitales Steuersignal $P_1' = 0$ und am dritten Eingang $E_3'$ ein digitales Steuersignal $P_2' = 1$ anliegt; diese digitalen Steuersignale $P_1'$, $P_2'$ stammen vom Digitalrechner R'. Das Tiefpassfilter F' bildet aus dem fünften periodischen Rechtecksignal $S_1'$ den arithmetischen Mittelwert $S_2'$ (Figur 6e), der vom Umsetzer U' digitalisiert und vom Digitalrechner R' als binärer Zahlenwert M' für den arithmetischen Mittelwert $S_2'$ abgespeichert wird.

Zur Bestimmung des oberen Signalpegels $SO_1'$ des fünften periodischen Rechtecksignals $S_1'$ wird der zweite Eingang $E_2'$ der digitalen Logikschaltung L' vom Digitalrechner R' mit einem digitalen Steuersignal $P_1' = 1$ und der dritte Eingang $E_3'$ mit einem digitalen Steuersignal $P_2' = 1$ beaufschlagt, während am ersten Eingang $E_1'$ das dritte periodische Rechtecksignal S' anliegt; am Ausgang A' der digitalen Logikschaltung L' erscheint somit der obere Signalpegel $SO_1'$ des fünften periodischen Rechtecksignals $S_1'$ (Figur 6f), der nach Durchlaufen des Tiefpassfilters F' als oberer Signalpegel $SO_2'$ (Figur 6g) dem Umsetzer U' zugeführt, von diesem digitalisiert und vom Digitalrechner R' als binärer Zahlenwert E' für den oberen Signalpegel $SO_1'$ des fünften periodischen Rechtecksignals $S_1'$ abgespeichert wird.

Zur Bestimmung des unteren Signalpegels $SU_1'$ des fünften periodischen Rechtecksignals $S_1'$ wird der zweite Eingang $E_2'$ der digitalen Logikschaltung L' vom Digitalrechner R' mit einem digitalen Steuersignal $P_1' = 0$ und der dritte Eingang $E_3'$ mit einem digitalen Steuersignal $P_2' = 0$ beaufschlagt, während am ersten Eingang $E_1'$ das dritte periodische Rechtecksignal S' anliegt; am Ausgang A' der digitalen Logikschaltung L' erscheint somit der untere Signalpegel $SU_1'$ des fünften periodischen Rechtecksignals $S_1'$ (Figur 6h), der nach Durchlaufen des Tiefpassfilters F' als unterer Signalpegel $SU_2'$ (Figur 6i) dem Umsetzer U' zugeführt, von diesem digitalisiert und vom Digitalrechner R' als binärer Zahlenwert N' für den unteren Signalpegel $SU_1'$ des fünften periodischen Rechtecksignals $S_1'$ abgespeichert wird.

Der Phasenwinkel $\alpha = \pi \cdot (M' - N')/(E' - N')$ zwischen den zwei zueinander phasenverschobenen Rechtecksignalen $S_V$, $S_R$ wird vom Digitalrechner R' berechnet und durch eine Anzeigeeinheit Z' in digitaler Form angezeigt. Zur Berechnung des Phasenwinkels $\alpha$ sowie zur Erzeugung der drei Kombinationen von digitalen Steuersignalen $P_1'$, $P_2'$ wird der Digitalrechner R' entsprechend programmiert; die Abfrage der Signale $S_1'$, $SO_1'$, $SU_1'$ am Ausgang A' der Logikschaltung L' erfolgt sequentiell in beliebiger Reihenfolge. In Figur 8 sind die Signale $S_1'$, $SO_1'$, $SU_1'$ am Ausgang A' der Logikschaltung L' als Funktion der Zustände der digitalen Steuersignale $P_1'$, $P_2'$ tabellarisch dargestellt.

Der Einfluss der Restwelligkeit am Ausgang des Tiefpassfilters F; F' kann durch wiederholte Ermittlung der Zahlenwerte M; M' und weitere Mittelwertbildung durch den Digitalrechner R; R' verringert werden.

**Patentansprüche**

1. Verfahren zur Ermittlung einer dem Tastverhältnis entsprechenden Grösse TV eines periodischen elektrischen Rechtecksignals (S), insbesondere bei digitalen elektrischen Positionsmesseinrichtungen, bei dem aus dem periodischen Rechtecksignal (S) der arithmetische Mittelwert ($S_2$) gebildet wird, dadurch gekennzeichnet, dass von einem Digitalrechner (R) gesteuert, jeweils zeitlich voneinander beabstandet, dieser arithmetische Mittelwert ($S_2$), der obere Signalpegel und der untere Signalpegel des periodischen Rechtecksignals (S) abgeleitet werden, dass der arithmetische Mittelwert ($S_2$), der obere Signalpegel und der untere Signalpegel jeweils für sich mittels eines Umsetzers (U) in einen Zahlenwert M, E, N umgewandelt werden und dass die erhaltenen Zahlenwerte M, E, N dem Digitalrechner (R) zur Berechnung der dem Tastverhältnis entsprechenden Grösse $TV = (M-N)/(E-M)$ zugeführt werden.

2. Verfahren zur Ermittlung des Phasenwinkels $\alpha$ zwischen zwei zueinander phasenverschobenen, periodischen elektrischen Rechtecksignalen ($S_V$, $S_R$), insbesondere bei digitalen elektrischen Positionsmesseinrichtungen, bei dem die beiden phasenverschobenen Rechtecksignale ($S_V$, $S_R$) zu einem dritten, periodischen Rechtecksignal (S') zusammengefasst werden und bei dem der arithmetische Mittelwert ($S_2'$) aus diesem dritten periodischen Rechtecksignal (S') gebildet wird, dadurch gekennzeichnet, dass von einem Digitalrechner (R') gesteuert, jeweils zeitlich voneinander beabstandet, dieser arithmetische Mittelwert ($S_2'$), der obere Signalpegel und der untere Signalpegel des dritten periodischen Rechtecksignals (S') abgeleitet werden, dass der arithmetische Mittelwert ($S_2'$), der obere Signalpegel und der untere Signalpegel jeweils für sich mittels eines Umsetzers (U') in einen Zahlenwert M', E', N' umgewandelt werden und dass die erhaltenen Zahlenwerte M', E', N' dem Digitalrechner (R') zur Berechnung des Phasenwinkels $\alpha = \pi \cdot (M'-N')/(E'-N')$ zugeführt werden.

3. Verfahren nach Anspruch 1, dadurch gekennzeichnet, dass das periodische Rechtecksignal (S) einem ersten Eingang ($E_1$) einer digitalen Logikschaltung (L) zugeführt wird, dass der Digitalrechner (R) einen zweiten Eingang ($E_2$) und einen dritten Eingang ($E_3$) der digitalen Logikschaltung (L) mit digitalen Steuersignalen ($P_1$, $P_2$) beaufschlagt, dass, vom Digitalrechner (R) mittels Kombinationen der digitalen Steuersignale ($P_1$, $P_2$) gesteuert, am Ausgang (A) der digitalen Logikschaltung (L) jeweils zeitlich voneinander beabstandet ein viertes periodisches Rechtecksignal ($S_1$), dessen oberer Signalpegel ($SO_1$) und dessen unterer Signalpegel ($SU_1$) auftreten, dass beim jeweiligen Durchlaufen einer elektronischen Baueinheit (F) aus dem vierten periodischen Rechtecksignal ($S_1$) dessen arithmetischer Mittelwert ($S_2$), aus dem oberen Signalpegel ($SO_1$) ein resultierender oberer Signalpegel ($SO_2$) und aus dem unteren Signalpegel ($SU_1$) ein resultierender unterer Signalpegel ($SU_2$) gebildet wird, die dem Umsetzer (U) zugeführt werden, der sie digitalisiert und in den Digitalrechner (R) einspeist.

4. Verfahren nach Anspruch 2, dadurch gekennzeichnet, dass das dritte periodische Rechtecksignal (S') einem ersten Eingang ($E_1'$) einer digitalen Logikschaltung (L') zugeführt wird, dass der Digitalrechner (R') einen zweiten Eingang ($E_2'$) und einen dritten Eingang ($E_3'$) der digitalen Logikschaltung (L') mit digitalen Steuersignalen ($P_1'$, $P_2'$) beaufschlagt, dass vom Digitalrechner (R') mittels Kombinationen der digitalen Steuersignale ($P_1'$, $P_2'$) gesteuert, am Ausgang (A') der digitalen Logikschaltung (L') jeweils zeitlich voneinander beabstandet ein fünftes Rechtecksignal ($S_1'$), dessen oberer Signalpegel ($SO_1'$) und dessen unterer Signalpegel ($SU_1'$) auftreten, dass beim jeweiligen Durchlaufen einer elektronischen Baueinheit (F') aus dem fünften periodischen Rechtecksignal ($S_1'$) dessen arithmetischer Mittelwert ($S_2'$), aus dem oberen Signalpegel ($SO_1'$) ein resultierender oberer Signalpegel ($SO_2'$) und aus dem unteren Signalpegel ($SU_1'$) ein resultierender unterer Signalpegel ($SU_2'$) gebildet wird, die dem Umsetzer (U') zugeführt werden, der sie digitalisiert und dem Digitalrechner (R') einspeist.

5. Verfahren nach Anspruch 1 oder 2, dadurch gekennzeichnet, dass die ermittelte Grösse (TV) bzw. der ermittelte Phasenwinkel ($\alpha$) in einer Anzeigeeinheit (Z; Z') in digitaler Form angezeigt wird und dass der Digitalrechner (R; R') die Anzeigeeinheit (Z; Z') beaufschlagt.

6. Verfahren nach einem der Ansprüche 1 bis 4, dadurch gekennzeichnet, dass der Zahlenwert (M; M') für den arithmetischen Mittelwert ($S_2$; $S_2'$) wiederholt ermittelt wird und dass diese wiederholt ermittelten Zahlenwerte im Digitalrechner (R; R') einer weiteren Mittelwertbildung unterzogen werden.

7. Anordnung zur Ermittlung einer dem Tastverhältnis entsprechenden Grösse (TV) eines periodischen elektrischen Rechtecksignals (S), insbesondere zur Verwendung bei digitalen elektrischen Positionsmesseinrichtungen, mit einer elektronischen Baueinheit (F) zur Bildung des arithmetischen Mittelwertes ($S_2$) aus diesem periodischen Rechtecksignal (S), die aus einem Tiefpass besteht, dessen Grenzfrequenz weit unterhalb der Frequenz des periodischen Rechtecksignals (S) liegt, dadurch gekennzeichnet, dass das periodische Rechtecksignal (S) an einem ersten Eingang ($E_1$) einer digitalen Logikschaltung (L) anliegt, an deren zweitem und drittem Eingang ($E_2$, $E_3$) je ein Steuerausgang eines Digitalrechners (R) angeschlossen ist, um das Auftreten eines vierten periodischen Rechtecksignals ($S_1$) oder dessen oberen Signalpegels ($SO_1$) oder dessen unteren Signalpegels ($SU_1$) am Ausgang (A) der digitalen Logikschaltung (L) zu steuern, dass der Ausgang (A) der digitalen Logikschaltung (L) über den Tiefpass (F) an einen Umsetzer (U) angeschaltet ist, der die ihm sequentiell zugeführten Signale ($S_2$, $SO_2$, $SU_2$) in Zahlenwerte (M, E, N) umwandelt und dem an seinen Ausgang angeschlossenen Digitalrechner (R) zuführt, und dass am Datenausgang des Digitalrechners (R) der Wert der aus den Zahlenwerten (M, E, N) für den arithmetischen Mittelwert ($S_2$), den oberen und den unteren Signalpegel ($SO_2$ und $SU_2$) berechneten Grösse (TV) anliegt.

8. Anordnung zur Ermittlung des Phasenwinkels ($\alpha$) zwischen zwei zueinander phasenverschobenen, periodischen elektrischen Rechtecksignalen ($S_V$, $S_R$), insbesondere zur Verwendung bei digitalen elektrischen Positionsmesseinrichtungen, mit einer elektronischen Gatterschaltung ($G_3'$), an deren Eingängen die zwei zueinander phasenverschobenen, periodischen Rechtecksignale ($S_V$, $S_R$) anliegen und deren Ausgang diese Rechtecksignale ($S_V$, $S_R$) zu einem dritten periodischen Rechtecksignal (S') zusammengefasst führt und mit einem ersten Eingang ($E_1'$) einer digitalen Logikschaltung (L') verbunden ist, wobei der Ausgang (A') der digitalen Logikschaltung (L') an eine elektronische Baueinheit (F') zur arithmetischen Mittelwertbildung angeschlossen ist, dadurch gekennzeichnet, dass die elektronische Gatterschaltung ($G_3'$) ein Exclusiv-Oder-Gatter ist, dass am zweiten und dritten Eingang ($E_2'$, $E_3'$) der digitalen Logikschaltung (L') je ein Steuerausgang eines Digitalrechners (R') angeschlossen ist, um das Auftreten eines fünften periodischen Rechtecksignals ($S_1'$) oder dessen oberen Signalpegels ($SO_1'$) oder dessen unteren Signalpegels ($SU_1'$) am Ausgang (A') der digitalen Logikschaltung (L') zu steuern, dass die elektronische Baueinheit (F') zur arithmetischen Mittelwertbildung als Tiefpass ausgeführt ist, dessen Grenzfrequenz weit unterhalb der Frequenzen der zwei zueinander phasenverschobenen Rechtecksignale ($S_V$, $S_R$) liegt, dass der Ausgang des Tiefpasses (F') an einen Umsetzer (U') angeschlossen ist, der die ihm sequentiell zugeführten Signale ($S_2'$, $SO_2'$, $SU_2'$) in Zahlenwerte (M', E', N') umwandelt und dem an seinen Ausgang angeschlossenen Digitalrechner (R') zuführt, und dass am Datenausgang des Digitalrechners (R') der Wert des aus den Zahlenwerten (M', E', N') für den arithmetischen Mittelwert ($S_2'$), den oberen und unteren Signalpegel ($SO_2'$ und $SU_2'$) berechneten Phasenwinkels ($\alpha$) anliegt.

9. Anordnung nach einem der Ansprüche 7 oder 8, dadurch gekennzeichnet, dass die digitale Logikschaltung (L; L') ein erstes Gatter ($G_1$; $G_1'$) aufweist, das ihren ersten und zweiten Eingang ($E_1$, $E_2$; $E_1'$, $E_2'$) enthält und dessen Ausgang mit einem Eingang eines zweiten Gatters ($G_2$; $G_2'$) verbunden ist, dessen anderer Eingang den dritten Eingang ($E_3$; $E_3'$) und dessen Ausgang den Ausgang (A; A') der digitalen Logikschaltung (L; L') bildet.

10. Anordnung nach Anspruch 9, dadurch gekennzeichnet, dass das erste Gatter ($G_1$; $G_1'$) ein Oder-Gatter und das zweite Gatter ($G_2$; $G_2'$) ein Und-Gatter ist.

**Revendications**

1. Procédé pour la détermination d'une grandeur TV, correspondant à un rapport durée/écart d'impulsion, d'un signal électrique rectangulaire périodique (S), en particulier pour les dispositifs de mesure de position électrique numérique, dans lequel à partir du signal rectangulaire périodique (S), on forme la valeur moyenne arithmétique ($S_2$), caractérisé par le fait que, commandés par un calculateur numérique (R), cette valeur moyenne arithmétique ($S_2$), le niveau supérieur et le niveau inférieur du signal rectangulaire périodique (S), sont respectivement dérivés à intervalles les uns des autres, que la valeur moyenne arithmétique ($S_2$), le niveau supérieur et le niveau inférieur du signal, sont respectivement transformés en une valeur numérique (M, E, N) au moyen d'un convertisseur U, et que les valeurs numériques obtenues (M, E, N) sont appliquées au calculateur numérique (R) pour le calcul de la grandeur $TV = (M-N)/(E-M)$ correspondant au rapport durée/écart d'impulsion.

2. Procédé pour la détermination de l'angle de phase $\alpha$ entre deux signaux électriques rectangulaires périodiques ($S_V$, $S_R$) déphasés l'un par rapport à l'autre, en particulier pour les dispositifs de mesure de position électrique numérique, dans lequel on réunit les deux signaux rectangulaires déphasés ($S_V$, $S_R$) en un troisième signal rectangulaire périodique (S') et dans lequel on forme la valeur moyenne arithmétique ($S_2'$) à partir de ce troisième signal rectangulaire périodique (S'), caractérisé par le fait que, commandés par un calculateur numérique (R'), cette valeur moyenne arithmétique ($S_2'$), le niveau supérieur et le niveau inférieur du troisième signal rectangulaire périodique (S') sont respectivement dérivés à intervalles les uns des autres, que la valeur moyenne arithmétique ($S_2'$), le niveau supérieur et le niveau inférieur du signal, sont respectivement transformés en une valeur numérique (M', E', N') au moyen d'un convertisseur (U') et que les valeurs numériques obtenues (M', E', N') sont appliquées au calculateur numérique (R') pour le calcul de l'angle de phase $\alpha = \pi (M'-N')/(E'-N')$.

3. Procédé selon la revendication 1, caractérisé par le fait qu'on applique le signal rectangulaire périodique (S) à une première entrée ($E_1$) d'un circuit logique numérique (L), que le calculateur numérique (R) envoie des signaux de commande numériques ($P_1$, $P_2$) à une deuxième entrée ($E_2$) et à une troisième entrée ($E_3$) du circuit logique numérique (L), que, commandé par le calculateur numérique (R) au moyen de combinaisons des signaux de commande numériques ($P_1$, $P_2$), on obtient respectivement à la sortie (A) du circuit logique numérique (L) et avec décalage dans le temps, un quatrième signal rectangulaire périodique ($S_1$), son niveau supérieur ($SO_1$) et son niveau inférieur ($SU_1$), qu'à chaque passage à travers une unité électronique (F), il se forme à partir du quatrième signal rectangulaire périodique ($S_1$), la valeur moyenne arithmétique ($S_2$), à partir du niveau de signal supérieur ($SO_1$) un niveau de signal supérieur résultant ($SO_2$) et, à partir du ni-

veau de signal inférieur ($SU_1$) un niveau de signal inférieur résultant ($SU_2$) qui sont envoyés au convertisseur (U) qui les numérise et les injecte dans le calculateur numérique (R).

4. Procédé selon la revendication 2, caractérisé par le fait qu'on applique le troisième signal rectangulaire périodique (S') à une première entrée ($E_1'$) d'un circuit logique numérique (L'), que le calculateur numérique (R') envoie des signaux de commande numériques ($P_1'$), $P_2'$) à une deuxième entrée ($E_2'$) et à une troisième entrée ($E_3'$) du circuit logique numérique ($L_1$), que, commandé par le calculateur numérique (R') au moyen de combinaisons des signaux de commande numériques ($P_1'$, $P_2'$), on obtient respectivement à la sortie (A') du circuit logique numérique (L') et avec décalage dans le temps, un cinquième signal rectangulaire ($S_1'$), son niveau supérieur ($SO_1'$) et son niveau inférieur ($SU_1'$), qu'à chaque passage à travers une unité électronique, (S'), il se forme, à partir du cinquième signal rectangulaire périodique ($S_1'$), sa valeur moyenne arithmétique ($S_2'$), à partir du niveau de signal supérieur ($SO_1'$) un niveau de signal supérieur résultant ($SO_2'$) et, à partir du niveau de signal inférieur ($SU_1'$) un niveau de signal inférieur résultant ($SU_2$) qui sont envoyés au convertisseur (U') qui les numérise et les injecte dans le calculateur numérique (R').

5. Procédé selon la revendication 1 ou 2, caractérisé par le fait que la grandeur déterminée (TV) ou l'angle de phase déterminé ($\alpha$) est visualisé sous forme numérique dans une unité d'affichage (Z; Z') et que c'est le calculateur numérique (R; R') qui commande l'unité d'affichage (Z; Z').

6. Procédé selon l'une des revendications 1 à 4, caractérisé par le fait que la valeur numérique (M; M') pour la valeur moyenne arithmétique ($S_2$; $S_2'$) est déterminée de façon répétitive et que ces valeurs numériques déterminées de façon répétitive sont soumises dans le calculateur numérique (R; R') à une autre formation de valeur moyenne.

7. Dispositif pour la détermination d'une grandeur (TV), correspondant à un rapport durée/écart d'impulsion, d'un signal électrique rectangulaire périodique (S), en particulier pour emploi dans les dispositifs de mesure de position électrique numérique, comprenant une unité électronique (F) qui sert à la formation de la valeur moyenne arithmétique ($S_2$) à partir de ce signal rectangulaire périodique (S) et qui est constituée par un filtre passe-bas dont la fréquence limite se situe bien en dessous de la fréquence du signal rectangulaire périodique (S), caractérisé par le fait que le signal rectangulaire périodique (S) est appliqué à une première entrée ($E_1$) d'un circuit logique numérique (L) à la deuxième et à la troisième entrées ($E_2$, $E_3$) duquel sont respectivement raccordées une sortie de commande d'un calculateur numérique (R) pour commander l'apparition d'un quatrième signal rectangulaire périodique ($S_1$) ou de son niveau de signal supérieur ($SO_1$) ou de son niveau de signal inférieur ($SU_1$) à la sortie (A) du circuit logique numérique (L), que la sortie (A) du circuit logique numérique (L) est reliée par le filtre passebas (F) à un convertisseur (U) qui transforme les signaux ($S_2$, $SO_2$, $SU_2$) qui lui sont amenés séquentiellement, en valeurs numériques (M, E, N) et les applique au calculateur numérique (R) raccordé à sa sortie, et qu'à la sortie des données du calculateur numérique (R) apparaît la valeur de la grandeur (TV) calculée à partir des valeurs numériques (M, E, N) pour la valeur moyenne arithmétique ($S_2$), le niveau de signal supérieur et le niveau de signal inférieur ($SO_2$ et $SU_2$).

8. Dispositif pour la détermination de l'angle de phase ($\alpha$) entre deux signaux électriques rectangulaires périodiques ($S_V$, $S_R$) déphasés l'un par rapport à l'autre, en particulier pour emploi dans des dispositifs de mesure de position électrique numérique, comprenant un circuit porte électronique ($G_3'$) aux entrées duquel sont appliqués les deux signaux rectangulaires périodiques ($S_V$, $S_R$) déphasés l'un par rapport à l'autre, et dont la sortie conduit ces signaux rectangulaires ($S_V$, $S_R$) réunis en un troisième signal rectangulaire périodique (S') et est raccordée à une première entrée ($E_1'$) d'un circuit logique numérique (L'), la sortie (A') du circuit logique numérique (L') étant reliée à une unité électronique (F') pour la formation de la valeur moyenne arithmétique, caractérisé par le fait que le circuit porte électronique ($G_3'$) est une porte OU exclusif, qu'à la deuxième et à la troisième entrées ($E_2'$, $E_3'$) du circuit logique numérique (L') sont respectivement raccordées des sorties de commande d'un calculateur numérique (R') pour commander l'apparition d'un cinquième signal rectangulaire périodique ($S_1'$) ou de son niveau de signal supérieur ($SO_1'$) ou de son niveau de signal inférieur ($SU_1'$) à la sortie (A') du circuit logique numérique ($L_1$), que l'unité électronique (F') pour la formation de la valeur moyenne arithmétique est réalisée en forme de filtre passe-bas dont la fréquence limite se situe bien en dessous des fréquences des deux signaux rectangulaires ($S_V$, $S_R$) déphasés l'un par rapport à l'autre, que la sortie du filtre passe-bas (F') est reliée à un convertisseur (U') qui transforme les signaux ($S_2'$, $SO_2'$, $SU_2'$) qui lui sont appliqués séquentiellement, en valeurs numériques (M', E', N') et les applique au calculateur numérique (M') relié à sa sortie, et que, à la sortie des données du calculateur numérique (R'), apparaît la valeur de l'angle de phase ($\alpha$) calculée à partir des valeurs numériques (M', E', N') pour la valeur moyenne arithmétique ($S_2'$), le niveau de signal supérieur et le niveau de signal inférieur ($SO_2'$ et $SU_2'$).

9. Dispositif selon l'une des revendications 7 ou 8, caractérisé par le fait que le circuit logique numérique (L; L') comporte une première porte ($G_1$; $G_1'$) qui contient sa première et sa seconde entrées ($E_1$, $E_2$; $E_1'$, $E_2'$), et dont la sortie est raccordée à une entrée d'une deuxième porte ($G_2$; $G_2'$) dont l'autre entrée forme la troisième entrée ($E_3$; $E_3'$) et dont la sortie forme la sortie (A; A') du circuit logique numérique (L; L').

10. Dispositif selon la revendication 9, caractérisé par le fait que la première porte ($G_1$; $G_1'$) est une porte OU et la deuxième porte ($G_2$; $G_2'$) une porte ET.

## Claims

1. Method for determining a value (TV), corresponding to the pulse-duty factor, of a periodic electric rectangular signal (S), particularly with digital electric position measuring devices, in which method the arithmetic mean ($S_2$) is formed from the periodic rectangular signal (S), characterised in that, controlled by a digital computer (R), this arithmetic mean ($S_2$), the upper signal level and the lower signal level of the periodic rectangular signal (S) are derived, in each case spaced apart from each other in time, that the arithmetic mean ($S_2$), the upper signal level and the lower signal level are in each case by themselves converted by means of a converter (U) into a numerical value M, E, N and that the numerical values M, E, N obtained are supplied to the digital computer (R) for calculating the value $TV = (M-N)/(E-M)$ corresponding to the pulse duty factor.

2. Method for determining the phase angle (α) between two periodic electric rectangular signals ($S_V$, $S_R$) which are shifted in phase with respect to each other, particularly with digital electric position measuring devices, in which method the two phase-shifted rectangular signals ($S_V$, $S_R$) are combined to form a third, periodic rectangular signal (S') and in which method the arithmetic mean ($S_2'$) is formed from this third periodic rectangular signal (S'), characterised in that, controlled by a digital computer (R'), this arithmetic mean ($S_2'$), the upper signal level and the lower signal level of the third periodic rectangular signal (S') are derived, in each case spaced apart from each other in time, that the arithmetic mean ($S_2'$), the upper signal level and the lower signal level are converted in each case by themselves by means of a converter (U') into a numerical value M', E', N' and that the numerical values M', E', N' obtained are supplied to the digital computer (R') for calculating the phase angle $\alpha = \pi \cdot (M'-N')/(E'-N')$.

3. Method according to Claim 1, characterised in that the periodic rectangular signal (S) is fed to a first input ($E_1$) of a digital logic circuit (L), that the digital computer (R) applies digital control signals ($P_1$, $P_2$) to a second input ($E_2$) and a third input ($E_3$) of the digital logic circuit (L), that, controlled by the digital computer (R) by means of combinations of the digital control signals ($P_1$, $P_2$), a fourth periodic rectangular signal ($S_1$), its upper signal level ($SO_1$) and its lower signal level ($SU_1$) occur at the output (A) of the digital logic circuit (L), in each case spaced apart from each other in time, that, whenever the fourth periodic rectangular signal ($S_1$) passes through an electronic assembly (F), the arithmetic mean ($S_2$), from the upper signal level ($SO_1$) a resultant upper signal level ($SO_2$) and from the lower signal level ($SU_1$) a resultant lower signal level ($SU_2$), which are fed to the converter (U) which digitises them and feeds them into the digital computer (R), are formed from this fourth periodic rectangular signal.

4. Method according to Claim 2, characterised in that the third periodic rectangular signal (S') is fed to a first input ($E_1'$) of a digital logic circuit (L'), that the digital computer (R') applies digital control signals ($P_1'$, $P_2'$) to a second input ($E_2'$) and a third input ($E_3'$) of the digital logic circuit (L'), that, controlled by the digital computer (R') by means of combinations of the digital control signals ($P_1'$, $P_2'$), a fifth rectangular signal ($S_1'$), its upper signal level ($SO_1'$) and its lower signal level ($SU_1'$) occur at the output (A') of the digital logic circuit (L'), in each case spaced apart from each other in time, that, whenever the fifth periodic rectangular signal ($S_1'$) passes through an electronic assembly (F'), the arithmetic mean ($S_2'$), from the upper signal level ($SO_1'$) a resultant upper signal level ($SO_2'$) and from the lower signal level ($SU_1'$) a resultant lower signal level ($SU_2'$), which are fed to the converter (U') which digitises them and feeds them to the digital computer (R'), are formed from this fifth periodic rectangular signal.

5. Method according to Claim 1 or 2, characterised in that the value (TV) determined or the phase angle (α) determined is displayed in digital form in a display unit (Z; Z') and that the digital computer (R; R') drives the display unit (Z; Z').

6. Method according to one of Claims 1 to 4, characterised in that the numerical value (M; M') for the arithmetic mean ($S_2$; $S_2'$) is repeatedly determined and that these repeatedly determined numerical value are subjected to a further averaging process in the digital computer (R; R').

7. Arrangement for determining a value (TV), corresponding to the pulse-duty factor, of a periodic electric rectangular signal (S), particularly for use with digital electric position measuring devices, comprising an electronic assembly (F) for forming the arithmetic mean ($S_2$) from this periodic rectangular signal (S), which assembly consists of a low-pass filter the cut-off frequency of which is far below the frequency of the periodic rectangular signal (S), characterised in that the periodic rectangular signal (S) is present at a first input ($E_1$) of a digital logic circuit (L), to the second and third input ($E_2$, $E_3$) of which one control output each of a digital computer (R) is connected in order to control the occurrence of a fourth periodic rectangular signal ($S_1$) or its upper signal level ($SO_1$) or its lower signal level ($SU_1$) at the output (A) of the digital circuit (L), and that the output (A) of the digital logic circuit (L) is connected via the low-pass filter (F) to a converter (U) which converts the signals ($S_2$, $SO_2$, $SU_2$) sequentially supplied to it into numerical values (M, E, N) and feeds these values to the digital computer (R) connected to its output, and that the magnitude of the value (TV) calculated from the numerical values (M, E, N) for the arithmetic mean ($S_2$), the upper and the lower signal level ($SO_2$ and $SU_2$) is present at the data output of the digital computer (R).

8. Arrangement for determining the phase angle (α) between two periodic electric rectangular signals ($S_V$, $S_R$) which are shifted in phase with respect to each other, particularly for use with digital electric position measuring devices, comprising an electronic gate circuit ($G_3'$), at the inputs of which the periodic rectangular signals ($S_V$, $S_R$) which are shifted in phase with respect to each other are present and the output of which carries these rectangular signals ($S_V$, $S_R$), combined to form a third periodic rectangular signal (S') and is connected to a first input($E_1'$) of a digital logic circuit (L'), the output (A') of the digital logic circuit (L') being connected to an electronic assembly (F') for forming the arithmetic mean, characterised in that the electronic gate circuit ($G_3'$) is an exclusive-OR gate, the second and third input ($E_2'$, $E_3'$) of the digital logic circuit (L') are each connected to one control output of a digital computer (R') to control the occurrence of a fifth periodic rectangular signal ($S_1'$) or its upper signal level ($SO_1'$) or its lower signal level ($SU_1'$) at the output (A') of the digital logic circuit (L'), that the electronic assembly (F') for forming the arithmetic mean is constructed as a low-pass filter the cut-off frequency of which is far below the frequencis of the rectangular signals ($S_V$, $S_R$) which are shifted in phase with respect to each other, that the output of the low-pass filter (F') is connected to a converter (U') which converts the signals ($S_2'$, $SO_2'$, $SU_2'$), sequentially supplied to it into numerical values (M', E, N') and feeds these signals to the digital computer (R') connected to its output, and that the value of the phase angle ($\alpha$) calculated from the numerical values (M', E', N') for the arithmetic mean ($S_2'$), the upper and lower signal level ($SO_2'$ and $SU_2'$) is present at the data output of the digital computer (R').

9. Arrangement according to one of Claims 7 or 8, characterised in that the digital logic circuit (L; L') is provided with a first gate ($G_1$; $G_1'$) which contains its first and second input ($E_1$, $E_2$; $E_1'$, $E_2'$) and the output of which is connected to an input of a second gate ($G_2$; $G_2'$) the other input of which forms the third input ($E_3$; $E_3'$) and the output of which forms the output (A; A') of the digital logic circuit (L; L').

10. Arrangement according to Claim 9, characterised in that the first gate ($G_1$; $G_1'$) has an OR gate and the second gate ($G_2$; $G_2'$) is an AND gate.

FIG. 1

1/5

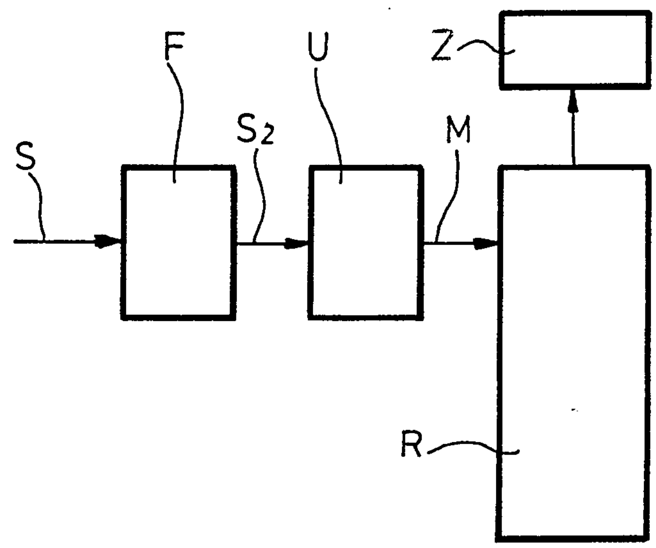


FIG. 2

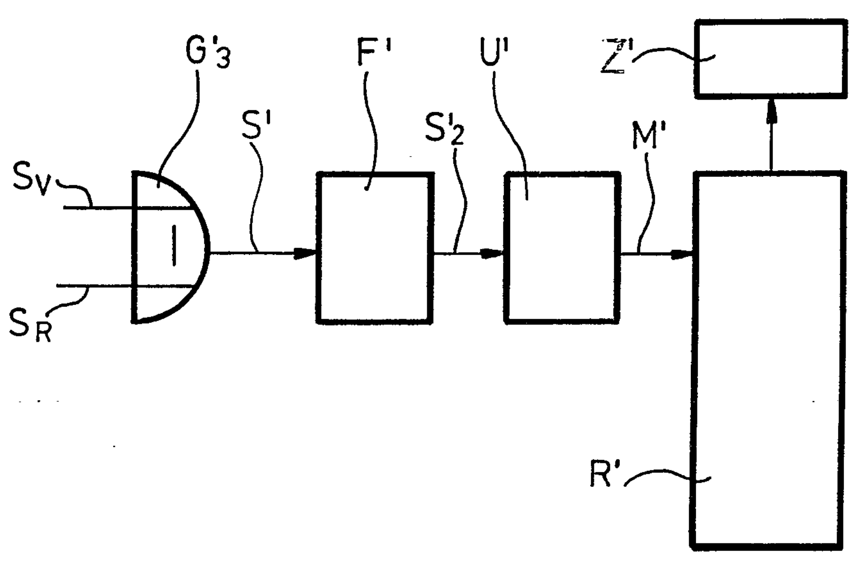

2/5

Fig. 3

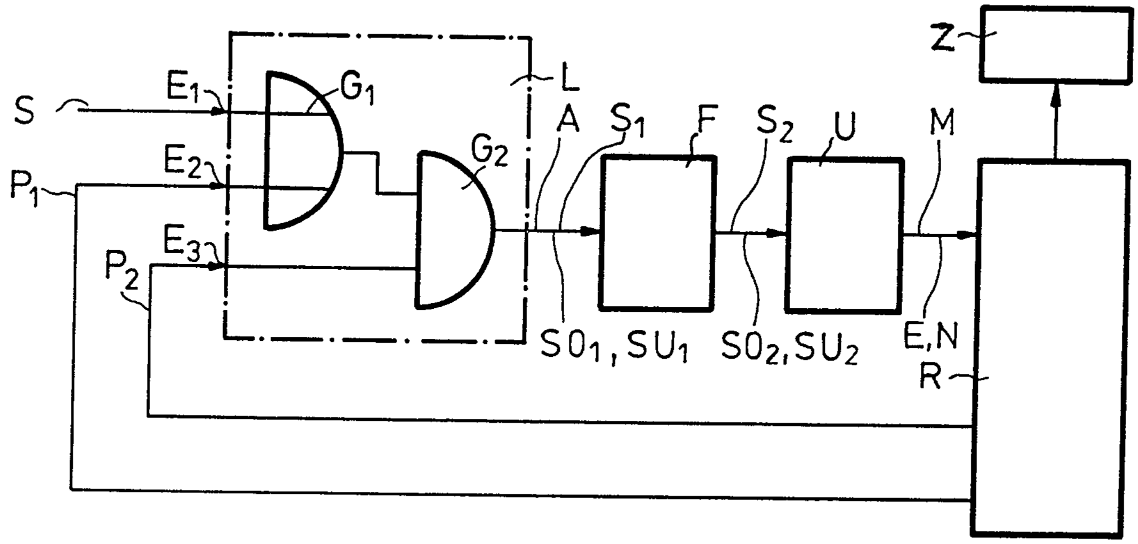
Z
L
S
E1
G1
E2
G2
P1
E3
P2
A
S1
F
S2
U
M
S01, SU1
S02, SU2
E, N
R

Fig. 4

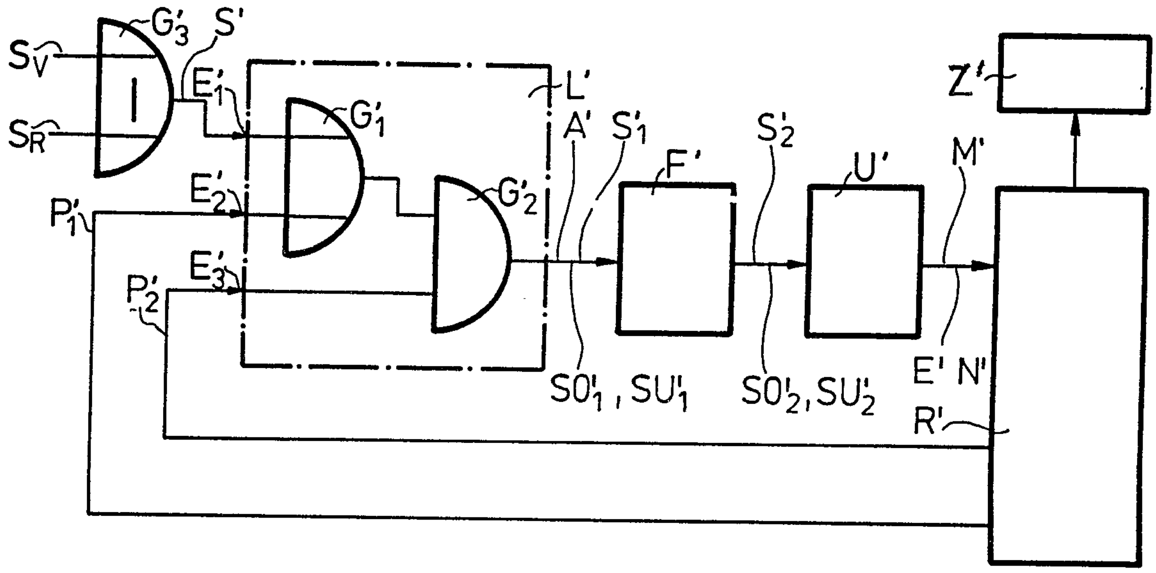
G'3
S'
SV
SR
I
E'1
G'1
L'
Z'
A'
S'1
S'2
F'
U'
M'
E'2
G'2
P'1
E'3
P'2
S0'1, SU'1
S0'2, SU'2
E' N'
R'

FIG. 5

3/5

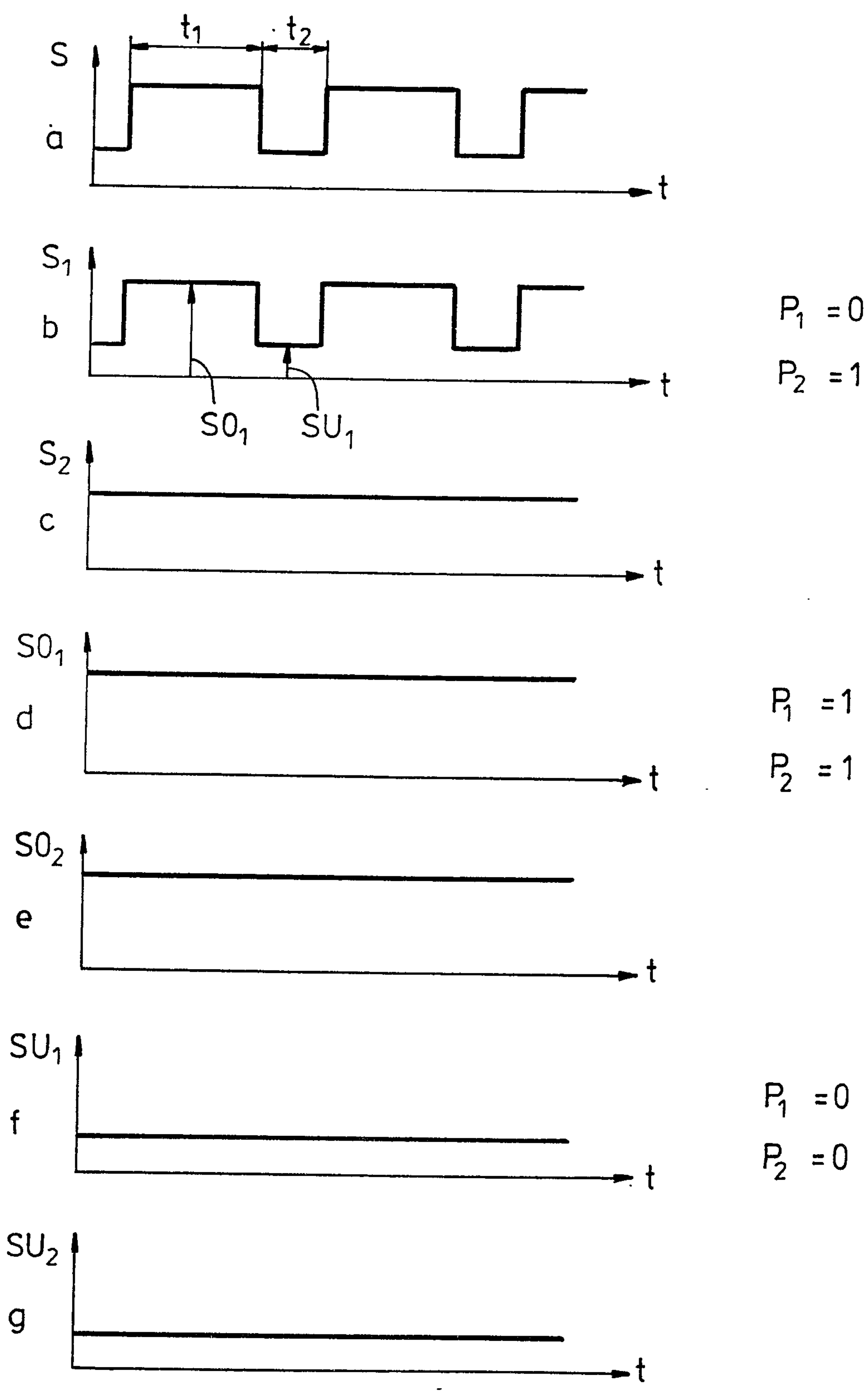
S
a
t
$t_1$
$t_2$
$S_1$
b
$SO_1$
$SU_1$
$P_1$ = 0
$P_2$ = 1
$S_2$
c
$SO_1$
d
$P_1$ = 1
$P_2$ = 1
$SO_2$
e
$SU_1$
f
$P_1$ = 0
$P_2$ = 0
$SU_2$
g

FIG. 6

4/5

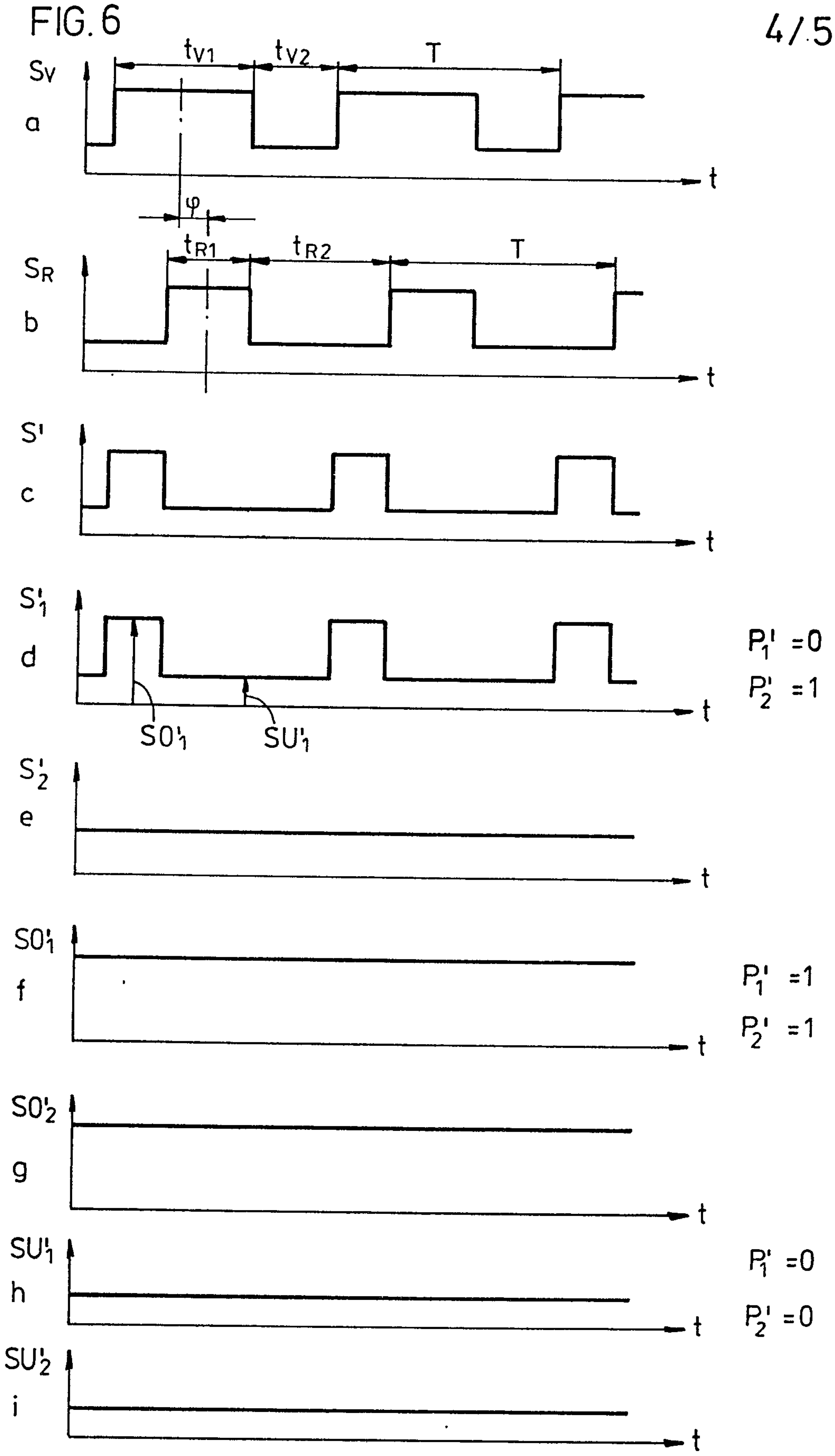
Sv
a
$t_{V1}$
$t_{V2}$
T
t
φ
$S_R$
b
$t_{R1}$
$t_{R2}$
T
t
S'
c
t
$S'_1$
d
t
S0'1
SU'1
$P_1'$ =0
$P_2'$ =1
$S'_2$
e
t
S0'1
f
t
$P_1'$ =1
$P_2'$ =1
S0'2
g
t
SU'1
h
t
$P_1'$ =0
$P_2'$ =0
SU'2
i
t

FIG. 7



| $P_1$ | $P_2$ | A |
|---|---|---|
| 0 | 0 | $SU_1$ |
| 1 | 0 | $SU_1$ |
| 0 | 1 | $S_1$ |
| 1 | 1 | $SO_1$ |

FIG. 8

| $P_1'$ | $P_2'$ | A' |
|---|---|---|
| 0 | 0 | $SU_1'$ |
| 1 | 0 | $SU_1'$ |
| 0 | 1 | $S_1'$ |
| 1 | 1 | $SO_1'$ |